# EUROPEAN PATENT APPLICATION

(11) **EP 2 538 448 A2**
(43) Date of publication of application: **26.12.2012**
(21) Application number: 12004629.7
(22) Date of filing: 20.06.2012
(51) Int. Cl.: H01L 31/0352

(54) **Solar cell**

(30) Priority: 20.06.2011 KR 20110059628
(71) Applicant: LG ELECTRONICS INC., Yeongdeungpo-gu Seoul 150-721 (KR)
(72) Inventor: Jin, Yoonsil, 137-724, Seoul (KR); Choi, Youngho, 137-724, Seoul (KR)
(74) Representative: Katérle, Axel

(57) **Abstract**

A solar cell includes a substrate having a first conductive type; an emitter layer formed on a front side of the substrate and having a second conductive type opposite to the first conductive type; a reflection preventing film on the emitter layer; and a plurality of finger lines that penetrate the reflection preventing film and are connected to the emitter layer. The emitter layer includes a plurality of first regions adjoining the plurality of front finger lines and a plurality of second regions disposed between the plurality of first regions, and the plurality of second regions have a thickness thicker than a thickness of the plurality of first regions. By doing so, a photovoltaic efficiency of the solar cell is improved.

## Description

### CROSS-REFERENCE TO RELATED APPLICATION

This application claims priority to and the benefit of Korean Patent Application No. 10-2011-0059628, filed on June 20, 2011 in the Korean Intellectual Property Office, the disclosure of which is incorporated herein by reference.

### BACKGROUND OF THE INVENTION

### 1. Field of the Invention

Embodiments of invention relates to a solar cell.

### 2. Description of the Related Art

Recently, as it is expected that conventional energy resources such as petroleum and coal will become exhausted, concern for alternative energy resources to replace the conventional energy resources has been gradually increasing. Among them, a solar cell is spotlighted as a new generation cell for directly converting solar energy into electric energy using a semiconductor device.

That is, a solar cell is a device for transforming light energy into electric energy using a photovoltaic effect, and is classified into a silicon solar cell, a thin film solar cell, a dye-sensitive solar cell, and an organic polymer solar cell. Among the solar cells, the silicon solar cell is mainly used. In the silicon solar cell, it is very important to increase an efficiency related to a ratio of converting solar light into electric energy.

### SUMMARY OF THE INVENTION

An aspect of the invention provides a solar cell having improved photovoltaic efficiency.

An aspect of the invention provides a solar cell including: a substrate having a first conductive type; an emitter layer formed on a front side of the substrate and having a second conductive type opposite to the first conductive type; a reflection preventing film on the emitter layer; and a plurality of finger lines that penetrate the reflection preventing film and are connected to the emitter layer; wherein the emitter layer includes a plurality of first regions adjoining the plurality of front finger lines and a plurality of second regions disposed between the plurality of first regions, and the plurality of second regions have a thickness thicker than a thickness of the first regions.

Another aspect of the invention provides a method of manufacturing a solar cell, the method including: forming an emitter layer by doping a first impurity having a second conductive type opposite to a first conductive type on a front side of a substrate having the first conductive type; forming a rear electric field layer by doping a second impurity having the first conductive type on a rear side of the substrate; and forming a plurality of front finger lines adjoining the emitter layer and a plurality of rear finger lines adjoining the rear electric field layer; wherein the emitter layer includes a plurality of first regions adjoining the plurality of front finger lines and a plurality of second regions disposed between the plurality of first regions, a doping concentration of the plurality of first regions is greater than a doping concentration of the plurality of second regions, and a doping thickness of the plurality of second regions is thicker than a doping thickness of the plurality of first regions.

The foregoing and other objects, features, aspects and advantages of the invention will become more apparent from the following detailed description of the embodiments when taken in conjunction with the accompanying drawings.

### BRIEF DESCRIPTION OF THE DRAWINGS

FIG. 1 is a perspective view of a solar cell according to an example embodiment of the invention.

FIG. 2 is a sectional view taken along the A-A' of the solar cell of FIG. 1.

FIG. 3 is a view illustrating a doping profile of an emitter layer of a solar cell according to an example embodiment of the invention.

FIG. 4 illustrates results of measuring varying resistance of the emitter layer having a doping profile in a solar cell as shown in FIG. 3.

FIG. 5 is a sectional view taken along line B-B' of the solar cell in FIG. 1.

FIG. 6 is a sectional view of a solar cell according to an example embodiment of the invention.

FIG. 7 is a sectional view of a solar cell according to an example embodiment of the invention.

FIGS. 8 to 11 are views illustrating a method of manufacturing a solar cell according to an example embodiment of the invention.

FIG. 12 is a sectional view of a solar cell module according to an example embodiment of the invention.

FIG. 13 is an enlarged view of a portion C of FIG. 12.

### DETAILED DESCRIPTION OF THE EMBODIMENTS

The terminology used herein is for the purpose of describing the embodiments of the invention only, and is not intended to be limiting of the embodiments of the invention.

Hereinafter, the drawings include reference to elements being all formed, installed, constructed "directly" or "indirectly", "on" or "under" of respective elements, and references to elements being "on" and "under" other elements will be described based on the drawings. The respective elements may be exaggerated, omitted, or schematically illustrated for illustrative convenience.

The invention may be embodied in many different forms and may have various embodiments, of which particular ones will be illustrated in the drawings and will be described in detail in the specification. However, it should be understood that the following example descriptions of the invention is not meant to restrict the invention to specific forms of embodiments of the invention, but rather, the embodiments of the invention are meant to cover all modifications, similarities and alternatives which are included in the spirit and scope of the invention.

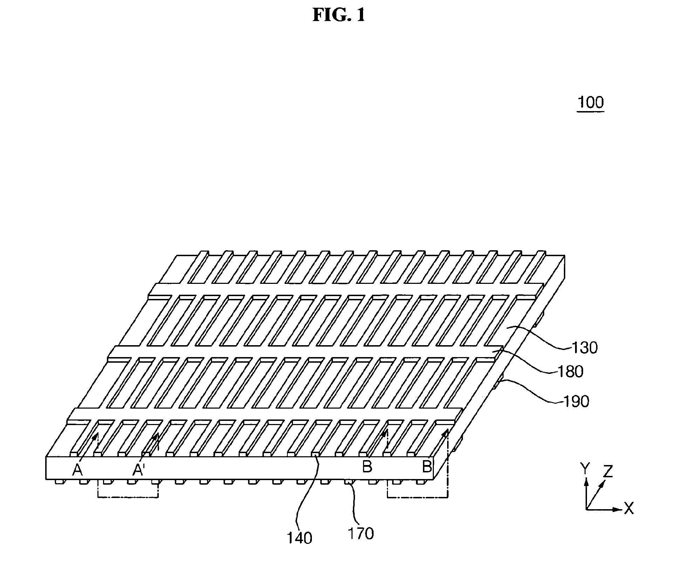

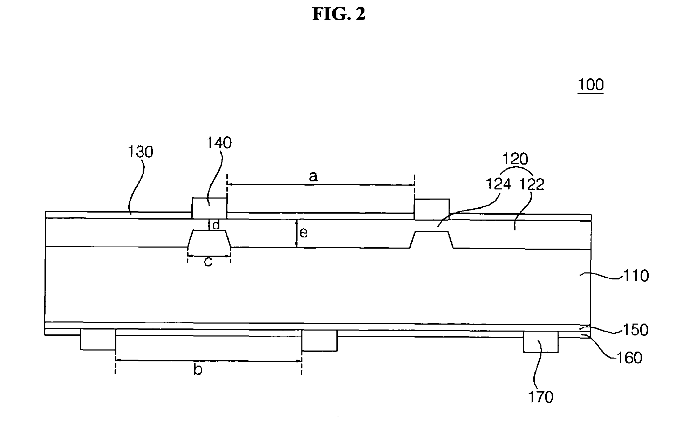

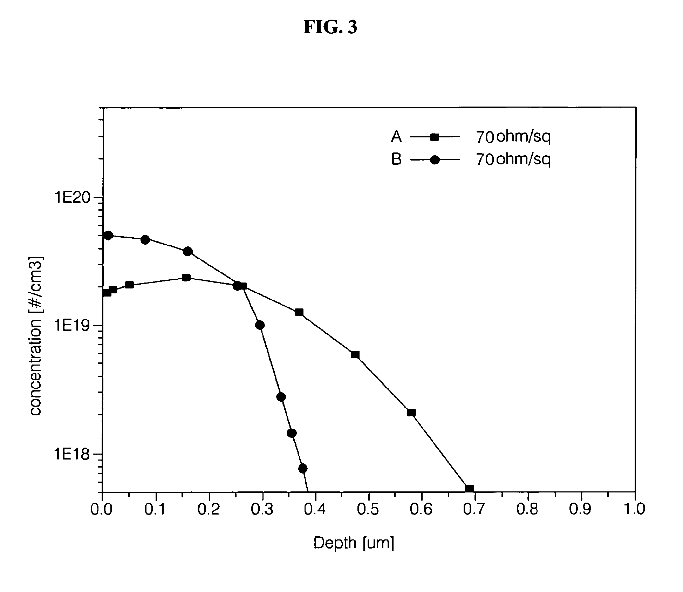

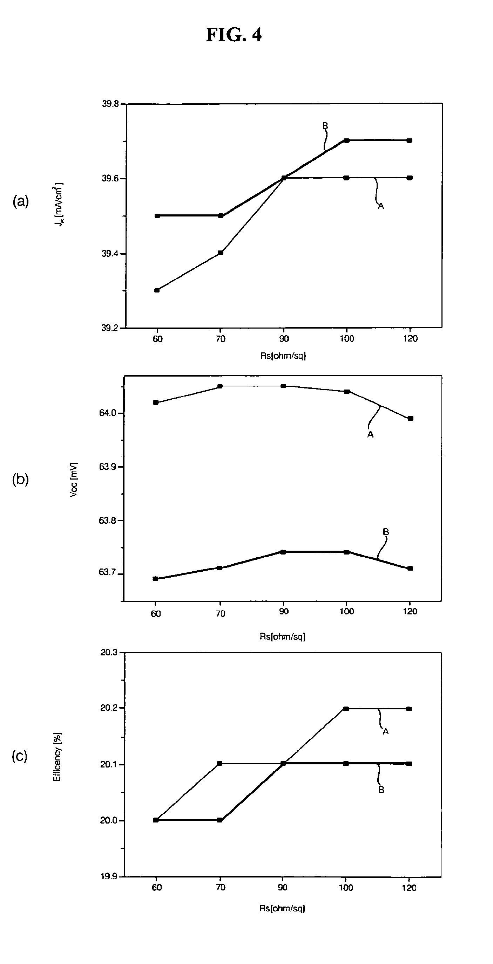

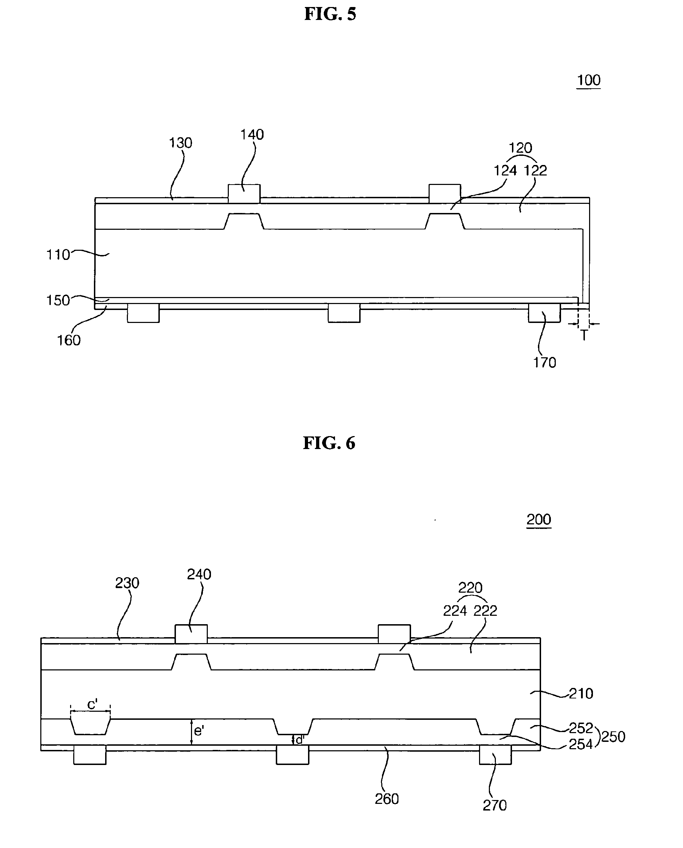

FIG. 1 is a perspective view of a solar cell according to an example embodiment of the invention. FIG. 2 is a sectional view taken along line A-A' of the solar cell of FIG. 1. FIG. 3 is a view illustrating a doping profile of an emitter layer of a solar cell according to an example embodiment of the invention. FIG. 4 illustrates results of measuring varying resistance of the emitter layer having a doping profile in a solar cell as shown in FIG. 3. FIG. 5 is a sectional view taken along line B-B' of the solar cell in FIG. 1. In this instance, FIGS. 2 and 5 are sectional views of the solar cell of FIG. 1 taken by cutting the solar cell in an X-Y plane and viewing the same in a Z-direction.

Referring to the drawings, a solar cell 100 according to an example embodiment of the invention may include a substrate 110 having a first conductive type, an emitter layer 120 positioned on a front side (a light incident side) of the substrate 110, a plurality of front finger lines 140 connected to the emitter layer 120, a rear electric field layer 150 on the other side (a non-light incident side) of the substrate 110, and a plurality of rear finger lines 170 connected to the rear electric field layer 150. The solar cell 100 may further include a first reflection preventing film 130 on the emitter layer 120 and a second reflection preventing film 160 on the rear electric field layer 150.

First, the substrate 110 may be made of silicon and may be doped with a P-type or an N-type impurity to have the first conductive type. For example, the silicon is doped with impurities of group III elements such as B, Ga, and In to be a P-type semiconductor, and the silicon is doped with impurities of group V elements such as P, As, and Sb to be an N-type semiconductor.

Meanwhile, the surfaces of the substrate 110 may be unevenness. The unevenness refers to an uneven pattern formed by texturing the surfaces of the substrate 110. As such, when the substrate 110 is textured, as will be described later, the emitter layer 120, the first reflection preventing film 130, the rear electric field layer 152, and the second reflection preventing film 160, which are formed on the substrate 110, may also be uneven or have an uneven pattern. Thus, reflectance of incident light into the solar cell 100 is reduced and optical trapping is increased so that optical loss in the solar cell 100 is reduced.

The emitter layer 120 is formed by doping a first impurity having a second conductive type opposite to the first conductive type of the substrate 110. For example, if the substrate 110 is a P type, the emitter layer 120 is doped with an N type impurity. When the substrate 110 is an N type, the emitter layer 120 is doped with a P type impurity. As such, when opposite conductive impurities are doped in the substrate 110 and the emitter layer 120, a P-N junction is formed at an interface between the substrate 110 and the emitter layer 120.

Meanwhile, the emitter layer 120 may include a first region 124 adjoining the plurality of front finger lines 140 and a second region 122 disposed between the plurality of front finger lines 140, that is, between a plurality of the first regions 124. According to the embodiment of the invention, doping a depth e of the second region 122 may be deeper than a doping depth d of the first region 124.

FIG. 3 is a view illustrating a doping profile of the emitter layer 120, wherein A shows the entire emitter layer 120 having the doping depth e of the second region 122 and B shows the entire emitter layer 120 having the doping depth d of the first region 124. In addition, A and B of FIG. 3 refers to the same legend in the lower area of the graph. That is, A of FIG. 3 shows a doping depth deeper than B, but having the same resistance as that of B. In FIG. 3, A and B all have a resistance of 70 Ω/sq.

FIG. 4 illustrates results of measuring varying resistance of the emitter layer having a doping profile in a solar cell as shown in FIG. 3. Referring to FIG. 4, Jsc of graph A, as shown in (a) of FIG. 4, is only slightly reduced than that of graph B when the doping depth of the emitter layer 120 of the graph A is deeper than that of the graph B. However, as shown in (b) FIG. 4, Voc of the graph A is remarkably increased than the graph B because surface recombination velocity (SRV) is improved since a doping concentration of surfaces of the graph A is lowered. As a result, as seen from (c) of FIG. 4, the overall efficiency of the solar cell of the graph A having the doping depth deeper than that of the graph B is improved over that of the graph B.

Referring back to the solar cell 100 according to the example embodiment of the invention, as illustrated in FIGS. 1 and 2, a thickness d of the first region 124 adjoining the front finger lines 140 is thinner than the thickness e of the second region 122 such that a reduction of Jsc due to an increase of Voc and recombination of carriers is compensated. Therefore, the doping thickness e of the second region 122 may be deeper than the doping thickness d of the first region 124.

In this instance, the second region 122 may have a thickness of 0.5µm to 2 µm. When the thickness e of the second region 122 is less than 0.5 µm, the SRV is increased due to increased concentration of the surface doping and Voc may be reduced. On the contrary, when the thickness e of the second region 122 is larger than 2 µm, Jsc is reduced as increased recombination of carriers. The thickness e of the second region 122 may be thicker than the thickness d of the first region 124 by 65% to 100%.

In addition, the first region 124 may be formed with a thickness of 0.3 µm to 1 µm. If the thickness d of the first region 124 is less than 0.3 µm, shunt between the front finger lines 140 and the emitter layer 120 may be generated. When the thickness d of the first region 124 is larger than 1 µm, recombination sites of minor carriers are increased and Jsc is significantly reduced because the first region 124, as will described later, is a high concentration doping region.

Therefore, in order to improve Voc of the solar cell 100 and to minimize reduction of Jsc so that the overall photovoltaic efficiency is improved, it is preferred, but not required, that the first region 124 has a doping thickness of 0.3 µm to 1 µm and the second region 122 has a doping thickness of 0.5 µm to 2 µm.

Meanwhile, since the more impurities exist in the emitter layer 120, the more electron-hole pairs are recombined by the photoelectric effect, it is advantageous that the second region 122 where light is mainly converted into electron-hole pairs has a relative lower concentration of the impurity and the first region 124 where separated electrons or holes migrate to the front finger lines 140 has a high concentration of the impurity for the reduction of contact resistance.

Therefore, in the solar cell 100 according to the example embodiment of the invention, the first region 124 at which the front finger lines 140 are positioned may be formed as a portion of the emitter layer 120 with a relative high concentration so as to reduce contact resistance against the front finger lines 140 and to prevent reduction of efficiency of the solar cell 100 due to recombination of carriers. Then, a surface resistance of the first region 124 of the emitter layer 120 may be less than a surface resistance of the second region 122.

The first region 124 of the emitter layer 120 may be designed to have a doping concentration of 1E19 to 1E21 and a surface resistance of 30Ω/sq. to 70Ω/sq., preferably, 40 Ω/sq. to 60 Ω/sq., and the second region 122 of the emitter layer 120 may be designed to have a doping concentration of 5E18 to 1E20 and a surface resistance of 70 Ω/sq. to 150 Ω/sq., preferably, 90 Ω/sq. to 120 Ω/sq.

Meanwhile, it is desired that a width c of the first region 124 being the high concentration doping region is larger than a width of the front finger lines 140, and a width difference between the first region 124 and the front finger lines 140 is less than 5 µm.

As described above, since the first region 124 of the emitter layer 120 is a region to which the first impurity is doped at a high concentration in order to reduce the contact resistance against the front finger lines 140, it is not easy to arrange the front finger lines 140 and the first region 124 to be aligned, and it is difficult for carriers to effectively migrate to the front finger lines 140 when the width c of the first region 124 is less than the width of the front finger lines 140, so as to reduce the efficiency of the solar cell 100.

Since the first region 124 is a region in which the first impurity is doped at a high concentration, a plurality of recombination sites of carriers exist in the first region 124. Therefore, when the width c of the first region 124 is wider than the width of the front finger lines 140, and a width difference between the first region 124 and the front finger lines 140 is larger than 5 µm, Jsc is reduced due to the increase of recombination of carriers. In this instance, the difference between the width c of the first region 124 and the width of the front finger lines 140 becomes a sum of distances from both ends of the front finger lines 140 to both ends of the first region 124 when the front finger lines 140 are positioned within the first region 124.

The first reflection preventing film 130, for example, may be a single layer film selected from a group consisting of silicon nitride, silicon oxide, silicon oxynitride, intrinsic amorphous silicon, MgF₂, ZnS, TiO₂ and CeO_{2,} or may be a multiple layer film in which at least two selected from the above group are combined. When the substrate 100 is a P type, the first reflection preventing film 130 functions as a passivation layer.

Therefore, the first reflection preventing film 130 eliminates the recombination site of the carriers on the surfaces of the emitter layer 120 or in the bulk of the emitter layer 120, and reduces reflectance of solar light entering the front side of the substrate 110. As such, when the recombination site of the carriers existing in the emitter layer 120 is eliminated, an open circuit voltage Voc of the solar cell 100 is increased. When reflectance of solar light is reduced, quantity of light reaching the P-N junction is increased and a short circuit current Isc of the solar cell 100 is also increased. As such, when the open circuit voltage Voc and the short circuit voltage Isc of the solar cell 100 are increased by the first reflection preventing film 130, the photovoltaic efficiency of the solar cell 100 may be improved commensurate to the increase in the quantity of light.

The first reflection preventing film 130 may have a refractive index of 1.8 to 2.5 and a thickness of 60 µm to 100 µm. Particularly, when the refractive index of the first reflection preventing film 130 is less than 1.8, effect of preventing the reflection of light is not significant. On the contrary, when the refractive index of the first reflection preventing film 130 is larger than 2.5, optical absorption occurs in the first reflection preventing film 130 in a wavelength range that contributes to incident light-to-current conversion, and the photovoltaic efficiency drops.

When the substrate 110 is an N type, a passivation layer may be further provided between the emitter layer 120 and the first reflection preventing film 130. The passivation layer may be made of SiOₓ and/or AlₓO_{y}.

The front finger lines 140 collect electrons or holes that are generated due to the photoelectric effect, and the number thereof may be plural.

For example, the front finger lines 140 may be formed by using a screen-printing paste containing AgAl, glass frit, etc., at positions where the front finger lines 140 will be formed using a mask in which openings are formed, and by performing a thermal annealing when the emitter layer 120 is the P type, for the ohmic contact with the emitter layer 120. The front finger lines 140 may be formed by the screen-printing paste containing Ag, glass frit, etc., and by performing a thermal annealing when the emitter layer 120 is the N type.

In addition, the front finger lines 140 may be formed by removing the first reflection preventing film 130 and/or the passivation layer by performing laser ablation while projecting a laser, then by depositing a seed layer with Ni, and then by another layer being deposited thereon by plating or sputtering. The front finger lines 140 formed as described above, may have a structure of Ni/Cu/Sn, Ni/Ag, or Ni/Cu/Ag, but the embodiments of the invention are not limited thereto. In addition, the front finger lines 140 may have a width that is wider than 10 µm and a height of 60 µm to 80 µm, but the embodiments of the invention are not limited thereto.

Meanwhile, the plurality of front finger lines 140 come into contact with a front bus electrode crossing the front finger lines 140. The front bus electrode 180 is connected to a ribbon to supply current generated from the solar cell 100 to the outside.

Since the rear electric field layer 150 is a high concentration doping region, the rear electric field layer 150 may be made to reduce or prevent recombination between separated electron-hole pairs, reduce a leak current, and to have improved ohmic contact. The rear electric field layer 150 may be made by doping a second impurity having the same first conductive type as that of the substrate 110.

FIG. 5 is a sectional view taken along line B-B' of a solar cell in FIG. 1. Referring to FIG. 5, the rear electric field layer 150 is spaced apart from a rear edge of the substrate 110 by a distance 'T'. This distance 'T' is to prevent a short from occurring between the rear electric field layer 150 and the emitter layer 120 because the first impurity may be doped in to lateral sides of the substrate 110 when the doping is performed to form the emitter layer 120. Therefore, as will be described later, an additional edge isolation process for preventing the short between the front side and the rear side of the substrate 110 may be omitted when the distance 'T' is present.

Although the second impurity for forming the rear electric field layer 150 may be contained or included within the distance T between the rear electric field layer 150 and the rear edge of the substrate 110 due to diffusion, this can be disregarded because the short between the rear electric field layer 150 and the emitter layer 120 does not occur when the distance'T' is sufficiently large.

When the distance T from the rear electric field layer 150 to the rear edge of the substrate 110 is less than 2 µm, the short between the rear electric field layer 150 and the emitter layer 120 may be generated due to diffusion of the impurity, and this may be the cause of a reduction of the efficiency of the solar cell 100. On the contrary, when the distance T from the rear electric field layer 150 to the rear edge of the substrate 110 is greater than 300 µm, an area (or a size) of the rear electric field layer 120 is reduced and recombination of the electron-hole pairs increases so that the efficiency of the solar cell 100 may be reduced. Therefore, the distance T from the rear electric field layer 150 to the rear edge of the substrate 110 is preferably 2 µm to 300 µm.

The second reflection preventing film 160 may be formed on the rear electric field layer 150. Therefore, the solar cell 100 according to the example embodiment of the invention may be a bifacial solar cell.

The second reflection preventing film 160 may be identical to the above-mentioned first reflection preventing film 130. That is, since the second reflection preventing layer 160, for example, may be a single layer film selected from a group consisting of silicon nitride, silicon oxide, silicon oxynitride, intrinsic amorphous silicon, MgF₂, ZnS, TiO₂, and CeO₂, or may be a multiple layer structure in which at least two selected from the above group are combined, the second reflection preventing film 160 reduces refractive index of solar light entering the rear side of the substrate 110 and functions as a passivation layer when the substrate 110 is an N type. The second reflection preventing layer 160 may have a refractive index of 1.8 to 2.5 and a thickness of 60 µm to 100 µm.

When the substrate 110 is a P type, a passivation layer may be further provided between the rear electric field layer 150 and the second reflection preventing film 160. The passivation layer may be formed with, for example, SiOₓ and/or AlₓO_{y}.

The rear finger lines 170 may be plural. The rear finger lines 170 may be formed by screen-printing a paste containing Ag, glass frit, etc., when the substrate 110 is the N type, for the ohmic contact with the rear electric field layer 150. The rear finger lines 170 may be formed using a paste containing AgAl, glass frit, etc., when the substrate is the P type.

In addition, the rear finger lines 170 may be formed by removing the first reflection preventing film 130 and/or the passivation layer by performing laser ablation while projecting a laser, then by depositing a seed layer with Ni, and then by another layer being deposited thereon by plating or sputtering. The rear finger lines 170 formed as described above, may have a structure of Ni/Cu/Sn, Ni/Ag, or Ni/Cu/Ag, but the embodiments of the invention are not limited thereto. In addition, the rear finger lines 170 may have a width that is wider than 10 µm and a height of 60 µm to 80 µm, but the embodiments of the invention are not limited thereto.

Meanwhile, the plurality of rear finger lines 170 come into contact with a rear bus electrode 190 crossing the rear finger lines 170 and may supply current generated due to the photoelectric effect to the outside.

The number of the rear finger lines 170 may be different from the number of the front finger lines 140 as any one of the finger lines 140 and 170 may be varied (e.g., increased). For example, the number of the rear finger lines 170 may be greater than the number of the front finger lines 140.

When the number of the rear finger lines 170 is greater than the number of the front finger lines 140, the overall resistance of the solar cell 100 may be reduced as migration distance of electrons or holes to the rear finger lines 170 becomes shorter. In addition, since the number of the front finger lines 140 does not need to be increased for the reduction of the overall resistance of the solar cell 100, no more optical absorption from the front side of the solar cell 100 is disturbed so that reduction of optical absorption of the solar cell 100 can be reduced or prevented.

In addition, a ratio of a distance b between two rear finger lines 170 adjacent to each other among the plurality of the rear finger lines 170 to a distance a between two front finger lines 140 adjacent to each other among the plurality of the front finger lines 140 (hereinafter, referred to as "b/a") is preferably, but not necessarily, greater than 0.25 and less than 1.

If the distance b between the adjacent rear finger lines 170 is reduced and b/a is less than 0.25, the area of the back side of the rear finger lines 170 increases and recombination of electron-hole pairs increases due to the metal in the rear finger lines 170. In addition, if the distance a between the adjacent front finger lines 140 increases and b/a is less than 0.25, migration distances of carriers to the rear finger lines 170 increases so that efficiency of the solar cell 100 is deteriorated.

On the contrary, when the distance b between the adjacent rear finger lines 170 increases and b/a is greater than 1, resistance increases due to an increase of the migration distances of carriers so that efficiency of the solar cell 100 is reduced. When the distance a between the front finger lines 140 is reduced and b/a is greater than 1, the area of the front side of the solar cell 100 that is covered by the front finger lines 140 shades the solar light from entering the front side of substrate 110, so that a Jsc may be reduced.

The distance b between two rear finger lines 170 adjacent to each other among the plurality of rear finger lines 170 may be from 0.5 µm to 2.5 µm. In this instance, the front finger lines 140 are arranged to satisfy the value of the above-mentioned b/a.

If the distance b between the adjacent rear finger lines 170 is less than 0.5 µm, recombination of electron-hole pairs increases due to an increase of the area of the solar cell 100 that is covered by the rear finger lines 170 and shades the solar light from entering the rear side of the substrate 110 so that a Jsc may be reduced. On the contrary, the distance b between the adjacent rear finger lines 170 is greater than 2.5 µm, a fill factor is reduced by the increase of resistance caused by an increase of the migration distances of carriers so that efficiency of the solar cell 100 may be reduced. Therefore, it is preferred, but not required, that the distance b between the two adjacent rear finger lines 170 is from 0.5 µm to 2.5 µm.

FIG. 6 is a sectional view of a solar cell according to an example embodiment of the invention. Referring to FIG. 6, a solar cell 200 according to another example embodiment of the invention may include a substrate 210, such as a silicon semiconductor substrate, having a first conductive type, an emitter layer 220 positioned on a front side of the substrate 210, a first reflection preventing film 230 on the emitter layer 220, a plurality of front finger lines 240 penetrating the first reflection preventing film 230 and connected to the emitter layer 220, a rear electric field layer 250 on the other side of the substrate 210, a second reflection preventing film 260 on the rear electric field layer 250, and a plurality of rear finger lines 270 penetrating the second reflection preventing film 260 and connected to the rear electric field layer 250.

Since the substrate 210, the emitter layer 220, the first reflection preventing film 230, the front finger lines 240, the second reflection preventing film 260, and the rear finger lines 270 are identical to those of FIGS 1 to 5, their detailed description will be omitted.

The rear electric field layer 250 of FIG. 6 may have the same structure as the emitter layer 220 having first regions 224 and second regions 221. That is, the rear electric field layer 250 includes third regions 254 adjoining the plurality of rear finger lines 270 and fourth regions 252 disposed between a plurality of the rear finger lines 270, that is between the plurality of third regions 254. Also, a doping depth e' of the fourth regions 252 may be greater than a doping depth d' of the third regions 254.

For example, the doping depth d' of the third regions 254 may be from 0.3 µm to 1 µm, which may be identical to that of the first regions 224, and the doping depth e' of the fourth regions 252 may be from 0.5 µm to 2 µm, which may be identical to that of the second regions 222. The thickness e' of the fourth region 252 may be thicker than the thickness d' of the third region 254 by 65% to 100%.

The solar cell 200 having this structure exhibits the same results as shown and described with reference to FIG. 4. That is, Jsc may be reduced but is compensated by reducing the doping depth d' of the third regions 254 and Voc is improved by increasing the doping depth e' of the fourth regions 252 so that the overall efficiency of the solar cell 200 may be significantly increased.

Meanwhile, the doping concentration of the impurity of the third regions 254 is greater than the doping concentration of the impurity of the fourth regions 252 so that contact resistance against the rear finger lines 270 may be reduced. In this instance, the third regions 254 may be designed to have a doping concentration of 1E19 to 1E21 and a surface resistance from 30 Ω/sq. to 70 Ω/sq., preferably, 40 Ω/sq. to 60 Ω/sq. The fourth regions 252 may be designed to have a doping concentration of 5E18 to 1E20 and a surface resistance from 70 Ω/sq. to 150 Ω/sq., preferably 90 Ω/sq. to 120 Ω/sq.

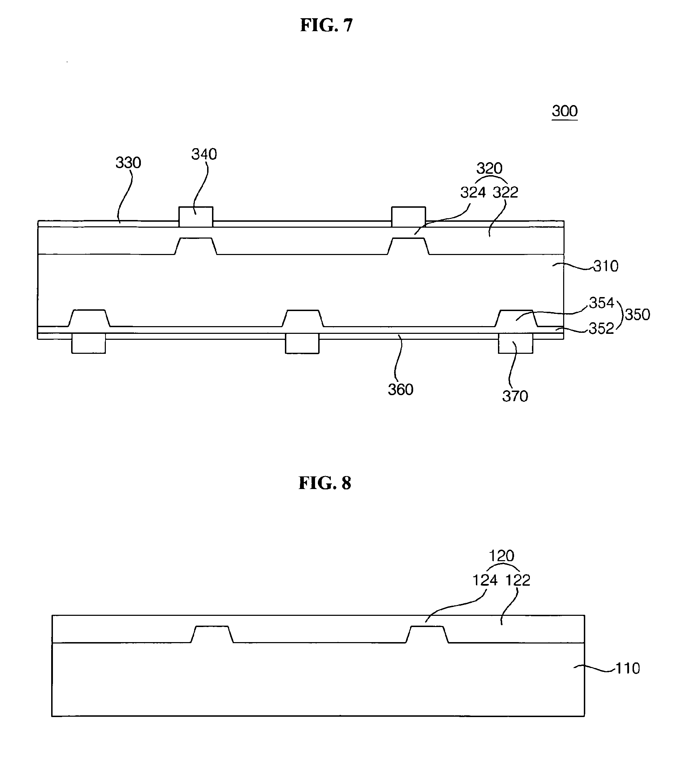

FIG. 7 is a sectional view of a solar cell according to an example embodiment of the invention. Referring to FIG. 7, a solar cell 300 according to an example embodiment of the invention may include a substrate 310, such as a silicon semiconductor substrate, having a first conductive type, an emitter layer 320 positioned on a front side of the substrate 310, a first reflection preventing film 330 on the emitter layer 320, a plurality of front finger lines 340 penetrating the first reflection preventing film 330 and connected to the emitter layer 320, a rear electric field layer 350 on the other side of the substrate 310, a second reflection preventing film 360 on the rear electric field layer 350, and a plurality of rear finger lines 370 penetrating the second reflection preventing film 360 and connected to the rear electric field layer 350.

Since the substrate 310, the emitter layer 320, the first reflection preventing film 330, the front finger lines 340, the second reflection preventing film 360, and the rear finger lines 370 are identical to those as illustrated and described with reference to FIGS. 1 to 5, their detailed description will be omitted.

The rear electric field layer 350 of FIG. 7 has a structure opposite to that of the rear electric field layer 250. That is, the rear electric field layer 350 of FIG. 7 has a doping thickness of a third region 354 adjoining the rear finger lines 370 greater than a doping thickness of a fourth region 352. Therefore, recombination between electrons and holes may be effectively prevented in the fourth region 352.

The structure of the solar cell 300 may be adopted for gain of a fill factor when an efficiency of a front side of a bifacial solar cell is considered more importance than an efficiency of a rear side thereof, that is, when a fill factor must be increased or when a resistance of the substrate 310 is high.

In order to reduce a contact resistance against the rear finger lines 370, the third region 354 of the rear electric field layer 350 has a doping concentration higher than that of the fourth region 352. Therefore, ability thereof to transfer electrons or holes that are generated from the rear electric field layer 350 due to photoelectric effect to the rear finger lines 370 is further improved so that photovoltaic efficiency of the solar cell 300 may be improved.

The third region 354 of the rear electric field layer 250 may have a doping concentration of 1E19 to 1E21 and the fourth region 322 may have a doping concentration of 5E18 to 1E20. The surface resistance of the rear electric field layer 350 may be designed to be 20Ω/sq. to 70Ω/sq., preferably, 40 Ω/sq. to 60 Ω/sq., and the surface resistance of the fourth region 352 thereof may be designed to be 60 Ω/sq. to 150 Ω/sq., preferably, 90 Ω/sq. to 120 Ω/sq.

Meanwhile, in order to prevent a shunt with the rear finger lines 170 and an increase of recombination of the carriers, the third region 354 may have a depth of 0.5 µm to 2 µm, and the fourth region 352 may have a thickness c of 0.3 µm to 1 µm to reduce or prevent recombination of the carriers and an increase of the resistance.

Particularly, since the rear finger lines 370 are not positioned on the fourth region 352, a thin rear electric field layer 350 can be formed. Therefore, transmission of blue-based light with short wavelength is increased so that the efficiency of the solar cell 300 may be improved.

FIGS. 8 to 11 are views illustrating a method of manufacturing a solar cell according to an example embodiment of the invention.

A method of manufacturing the solar cell according to an example embodiment of the invention will be described with reference to FIGS. 8 to 11. First, as illustrated in FIG. 8, a first impurity having a second conductive type opposite to a first conductive type is doped in the substrate 110 having the first conductive type to form the emitter layer 120.

The substrate 110 may have an unevenness structure. The unevenness structure may reduce reflectivity of incident solar light and increase optical trapping so that optical loss of the solar cell 100 can be reduced. The unevenness structure may be made by soaking the substrate 110 into an etchant and may be formed in various types or shapes, such as a pyramid type or shape, a right triangle type or shape, a triangle type or shape, etc.

The emitter layer 120 may be formed by injecting the first impurity into the substrate 110 by ion implantation. The ion implantation is a method of supplying energy to the first impurity to be injected into the substrate 110, and precisely controls a quantity of the first impurity to be injected by controlling injected energy, quantity to be used, and a doping depth. Therefore, by using the ion implantation, the first region 124 of the emitter layer 120 having a shallow doping depth and a high doping concentration, and the second region 122 of the emitter layer 120 having a deep doping depth and a low doping concentration can be easily formed in contrast to diffusion.

Meanwhile, the first region 124 and the second region 122 of the emitter layer 120 may be sequentially formed using masks with openings that are formed at different positions. That is, the first region 124 may be formed using a mask in which an opening is formed at which the first region 124 is to be formed and the second region 122 may be formed independently from the first region using another mask in which an opening is formed at which the second region 122 is to be formed. In addition, the emitter layer 120 may be formed by the ion implantation, for example, using a comb mask.

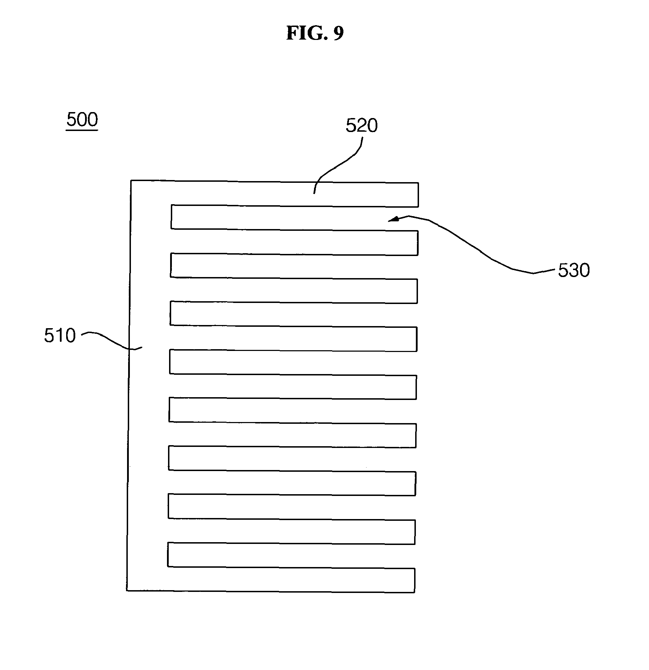

FIG. 9 is a view illustrating a comb mask. Referring to FIG. 9, a comb mask 500 includes a support 510 and a plurality of spokes 520, wherein the spokes 520 form slots 530, that is, openings between the spokes 520. For example, a method of forming the emitter layer 120 using the comb mask 500 will be described in brief. The comb mask 500 is fixed on the substrate 110 and the first impurity is injected onto the substrate 110 through the slots 530 to form the first region 124 of the emitter layer 120. After forming of the first region 124, the substrate 110 located under the comb mask 500 is moved and the first impurity is still injected to the substrate 110 to form the second region 122. At this time, doping concentrations of the first region 124 and the second region 122 may be controlled by adjusting an injection time of ions of the first impurity, a quantity of the ions to be doped, and an acceleration energy of the ions.

The second region 122 of the emitter layer 120 may have a doping thickness of 0.5 µm to 2 µm and the first region 124 may have a doping thickness of 0.3 µm to 1 µm. In addition, the first region 124 may be designed to have a doping concentration of 1E19 to 1E21 and a surface resistance of 30 Ω/sq. to 70 Ω/sq., preferably, 40 Ω/sq. to 60 Ω/sq., and the second region 122 may be designed to have a doping concentration of 5E18 to 1E20 and a surface resistance of 70 Ω/sq. to 150 Ω/sq., preferably 90 Ω/sq. to 120 Ω/sq.

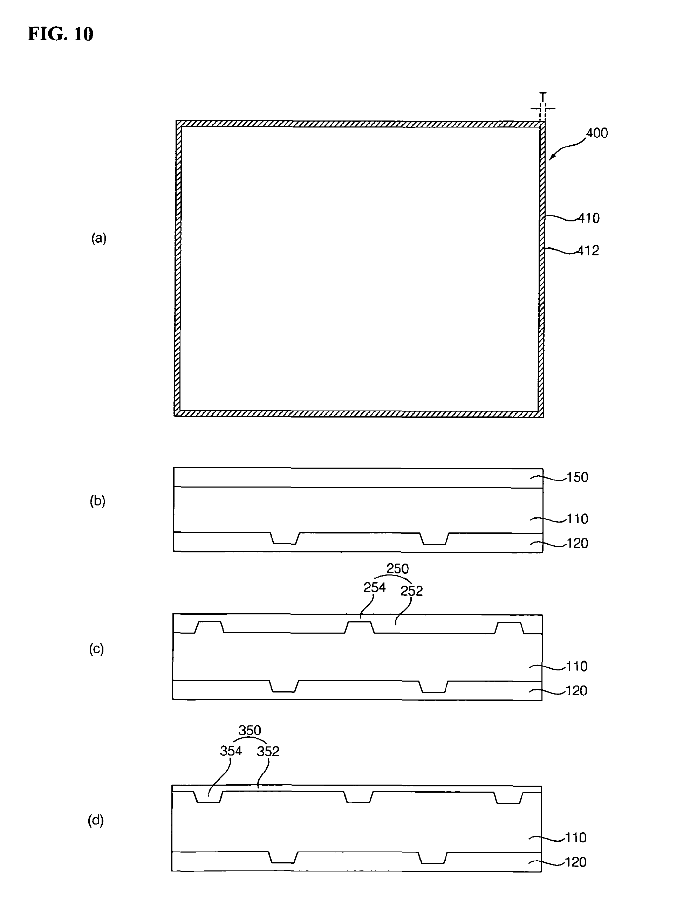

Next, as illustrated in FIG. 10, the second impurity having the first conductive type is doped to form the rear electric field layer 150. The rear electric field layer 150 prevents recombination between electron and hole pairs on the rear side of the substrate 110.

The rear electric field layer 150, for example, as illustrated in (a) of FIG. 10, may be formed by which the second impurity is doped using a mask 400 (shown cross-hatched) for covering the rear edge portion 410 of the substrate 110 as shown in (b) of FIG. 10. The rear electric field layer 150 may be formed by any one of thermal diffusion, laser doping, and ion implantation. In embodiments of the invention, the mask 400 may be in a shape of a rectangular hoop.

Since the mask 400 used to form the rear electric field layer 150 covers a distance of the distance T from the rear edge 412 of the substrate 110, the mask 400 can prevent the rear electric field layer 150 from in coming contact with a portion of the emitter layer 120 that would be formed on the lateral side of the substrate 110. Therefore, an additional edge isolation process for insulating the front side of the substrate 110 from the rear side thereof may be omitted.

By doing so, as described with reference to FIG. 5, the rear electric field layer 150 is spaced apart from the rear edge of the substrate 110 to the extent of the distance 'T'. In this instance, the distance T from the rear electric field layer 150 to the rear edge of the substrate 110 may be 2µm to 300µm.

Meanwhile, the rear electric field layers 250 and 350 may have structures as illustrated in (c) and (d) of FIG. 10, respectively. (c) of FIG. 10 shows the same structure of the rear electric field layer 250 illustrated in FIG. 6 and (d) of FIG. 10 shows the same structure of rear electric field layer 350 illustrated in FIG. 7.

First, the rear electric field layer 250 having the structure as illustrated in (c) of FIG. 10 has the same structure as that of the emitter layer 120. That is, the rear electric field layer 250 includes the third region 254 having a shallow doping depth and a high doping concentration, and the fourth region 252 having a deep doping depth and a low doping concentration.

The rear electric field layer 250 may be formed by ion implantation like the emitter layer 120. In addition, the third region 254 and the fourth region 252 may be formed independently using masks in which openings are formed at different positions, or at once using the comb masks as illustrated in FIG. 9.

The third region 254 may be formed to have a doping depth of 0.3 µm to 1 µm, a doping concentration of 1E19 to 1E21, and a surface resistance of 30 Ω/sq. to 70 Ω/sq., and the fourth region 252 may be formed to have a doping depth of 0.5 µm to 2 µm, a doping concentration of 5E18 to 1E20, and a surface resistance of 70 Ω/sq. to 150 Ω/sq.

Next, the rear electric field layer 350 having the structure as illustrated in (d) FIG. 10 has a structure opposite to that of the emitter layer 120. The third region 354 of the rear electric field layer 350 having the structure shown in (d) of FIG. 10 may be formed by first doping the second impurity on the entire rear side of the substrate 110 by use of any one of thermal diffusion, laser doping, and ion implantation to form the fourth region 352, then by subsequently positioning a mask having openings corresponding to positions where the plurality of rear finger lines 170 are to be formed, and by secondarily doping the second impurity by ion implantation to thereby finally form the third region 354.

The third region 354 formed by the secondary doping has a doping concentration higher than that of the fourth region 352. In addition, the third region 354 may be formed at once by using the comb mask as illustrated in FIG. 9 in another embodiment of the invention.

This structure may be adopted for the gain of a fill factor when the efficiency of the front side of the bifacial solar cell is considered to be more important rather than the efficiency of the rear side, that is, when the fill factor must be increased or when the resistance of the substrate 110 is high.

Meanwhile, the rear electric field layer 250 of (c) of FIG. 10 and the rear electric field layer 350 of (d) of FIG. 10 may be also spaced apart from the edge of the substrate 110 by the distance 'T' 2 µm to 300 µm.

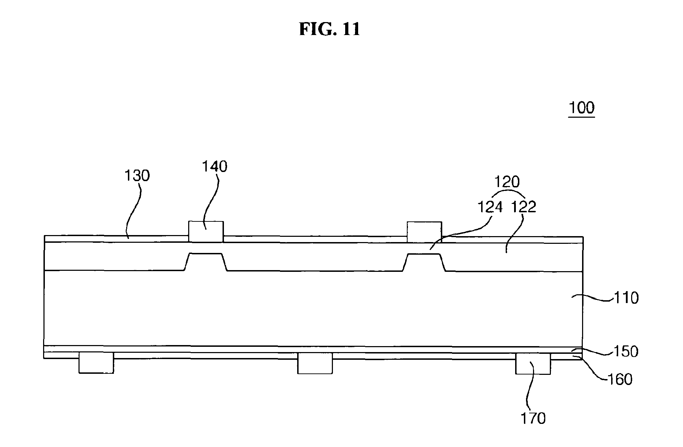

Next, as illustrated in FIG. 11, the first reflection preventing film 130 and the front finger lines 140 are formed on the emitter layer 120, and the second reflection preventing film 160 and the rear finger lines 170 are formed on the rear electric field layer 150. In addition, passivation layers may be further formed on the emitter layer 120 and the rear electric field layer 150.

The first reflection preventing film 130 and the second reflection preventing film 160 may be formed by vacuum deposition, chemical vapor deposition, spin coating, screen printing, or spray coating, but the embodiments of the invention are not limited thereto.

The front finger lines 140, for example, may be formed by screen-printing a paste, for forming a front electrode that includes the front finger lines 140, on portions of the front side of the substrate 110 where the front finger lines 140 are to be formed using a mask and by performing annealing. Silver contained in the printed paste is connected to the first region 124 of the emitter layer 120 due to a fire through phenomenon, whereby the silver penetrates through the first reflection preventing film 130 by use of glass frit that becomes liquefied at high temperature during plastic working thereon and is crystallized again thereafter. In embodiments of the invention, plastic working refers to processing that includes processing metals or other substances that cause a permanent change in their shapes without rupturing.

In addition, the front finger lines 140 may be formed by performing laser ablation to remove the first reflection preventing film 130 and/or the passivation layer by projecting a laser, then by depositing a seed layer made of Ni, and then by performing plating or sputtering another layer thereon. The front finger lines 140 may also be formed by screen printing after performing the laser firing and the laser ablation, but the embodiments of the invention are not limited thereto.

Since the rear finger lines 170 may be formed by the same method as the method of forming the front finger lines 140, its detailed description will be omitted.

The number of the rear finger lines 170 may be different from the number of the front finger lines 140 in order to prevent the resistance of the solar cell 100 from being reduced and the photovoltaic efficiency of the solar cell 100 from being deteriorated. In embodiments of the invention, the number of the rear finger lines 170 may be greater than the number of the front finger lines 140.

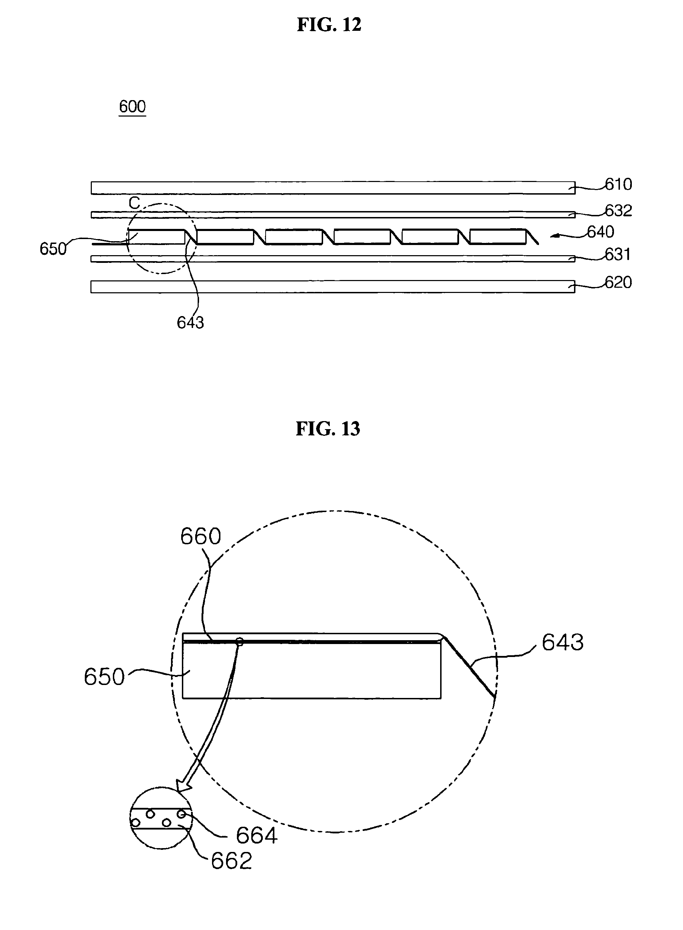

FIG. 12 is a sectional view of a solar cell module according to an example embodiment of the invention. FIG. 13 is an enlarged view of a portion C of FIG. 12.

Referring to FIG. 12, a solar cell module 600 according to an example embodiment of the invention may include a plurality of solar cells 650, a plurality of ribbons 643 for electrically connecting the plurality of solar cells 650, a first sealing film 631 and a second sealing film 632 for sealing the plurality of solar cells 650 at both sides thereof, a front substrate 610 for protecting one of the sides of the solar cells 650, and a rear substrate 620 for protecting the other of the sides of the solar cells 650.

Since each of the solar cells 650 are identical to the solar cell as illustrated in and described with reference to FIGS. 1 to 7, their detailed description will be omitted.

The plurality of solar cells 650 are electrically connected to each other by the ribbons 643 to form a string 640. Two lines of the ribbons 643 may be attached to the upper and lower sides of each of the solar cells 650 respectively by tabbing, and electrically connect the plurality of solar cells 650. That is, the tabbing process may be performed by coating flux on one of the sides of the solar cells 650, by positioning the ribbons 643 to the solar cells 650 coated with flux, and by performing plastic working thereon.

Alternatively, as illustrated in FIG. 13, the plurality of solar cells 650 may be connected to each other in series or parallel by attaching a conductive film 660 between the one of the sides of the solar cells 650 and the ribbons 643 and by thermally pressing the same.

The conductive film 650 may include a base film and conductive particles dispersed on/in the base film 662. The conductive particles 664 may be exposed out of the base film 662 by the thermal pressing and the solar cells 650 may be electrically connected to the ribbons 643 by the exposed conductive particles 664.

The base film 662 may be made of a thermosetting resin with excellent adhesive and insulation properties, such as an epoxy resin, an acryl resin, a polyimide resin, and a polycarbonate resin, and the conductive particles 664 may be particles of, for example, gold, silver, nickel, and copper which have excellent conductivity. The conductive particles 664 may be particles in which at least one of the above-mentioned metals is coated on polymer particles.

As such, when the plurality of solar cells 650 are connected by the conductive film to form a module, processing temperature is lowered so that bending of the string 640 can be prevented.

Referring to FIG. 12 again, the first sealing film 631 and the second sealing film 632 seal the plurality of solar cells 650 at both sides. The first sealing film 631 and the second sealing film 632 are combined by lamination to block moisture and oxygen that would adversely affect the solar cells 650.

In addition, the first sealing film 631 and the second sealing film 632 make respective elements of the solar cells 650 chemically bonded to each other. Ethylene-vinyl acetate copolymer resin (EVA), polyvinyl butyral, ethylene-vinyl acetate partial oxide, silicone resin, ester based resin, and olefin based resin may be used as the first sealing film 631 and/or the second sealing film 632.

The front substrate 610 is positioned on the first sealing film 631 to allow solar light to penetrate therethrough, preferably tempered glass, in order to protect the solar cells 650 from external shock. In addition, the front substrate 610 is more preferably low iron tempered glass in order to reduce or prevent solar light from being reflected and to increase transmission of solar light.

The rear substrate 620 is a layer for protecting the other of the sides of the solar cells 650 and for performing water-proof, insulation, and blocking of ultraviolet rays, and may be Tedlar/PET/Tedlar type, but is not limited thereto. The rear substrate 620 may be made of a transparent material such that solar light can enter.

The solar cell according to the embodiments of the invention, as described above, is not only made by applying the structures and the methods as described in the above embodiments but by all of the respective embodiments or combination of the above-mentioned embodiments.

As described above, according to the embodiments of the invention, the doping depth of the emitter layer that is not connected to the front finger lines is deeper than the doping depth of the high concentration doping region adjoining the finger lines so that photovoltaic efficiency of the solar cell can be improved.

## Claims

1. A solar cell comprising:
a substrate having a first conductive type;
an emitter layer formed on a front side of the substrate and having a second conductive type opposite to the first conductive type;
a reflection preventing film on the emitter layer; and
a plurality of finger lines that penetrate the reflection preventing film and are connected to the emitter layer;
wherein the emitter layer includes a plurality of first regions adjoining the plurality of front finger lines and a plurality of second regions disposed between the plurality of first regions, the plurality of second regions having a thickness thicker than a thickness of the plurality of first regions.

2. The solar cell of claim 1, wherein the plurality of first regions have a doping concentration higher than a doping concentration of the plurality of second regions.

3. The solar cell of claim 1, wherein the plurality of first regions have a thickness of 0.3 µm to 1 µm and the plurality of second regions have a thickness of 0.5 µm to 2 µm.

4. The solar cell of claim 1, wherein a width of the plurality of first regions is wider than that of the plurality of front finger lines and has a difference with the width of the plurality of front finger lines of less than 5 µm.

5. The solar cell of claim 1, further comprising:
a rear electric field layer on a rear side of the substrate facing the front side; and
a plurality of rear finger lines connected to the rear electric field layer;
wherein the number of the plurality of rear finger lines is greater than the number of the plurality of front finger lines.

6. The solar cell of claim 5, wherein a ratio of a distance between two adjacent rear finger lines of the plurality of rear finger lines to a distance between two adjacent front finger lines of the plurality of front finger lines is greater than 0.25 and less than 1.

7. The solar cell of claim 5, wherein the rear electric field layer is doped with an impurity having the first conductive type, and includes:
a plurality of third regions to which the plurality of rear finger lines adjoin; and
a plurality of fourth regions disposed between the plurality of third regions;
wherein a doping concentration of the third regions is higher than a doping concentration of the plurality of fourth regions.

8. The solar cell of claim 7, wherein the plurality of fourth regions have a thickness greater than a thickness of the plurality of third regions.

9. The solar cell of claim 7, wherein the plurality of third regions have a thickness greater than a thickness of the plurality of fourth regions.

10. The solar cell of claim 5, further comprising a second reflection preventing film on the rear electric field layer, wherein the plurality of rear finger lines penetrate the second reflection preventing film to adjoin the rear electric field layer.

11. The solar cell of claim 5, wherein the rear electric field layer is spaced apart from a rear edge of the substrate.

12. The solar cell of claim 11, wherein a distance from the rear electric field layer to the rear edge of the substrate is 2µm to 300µm.

13. A method of manufacturing a solar cell, the method comprising:
forming an emitter layer by doping a first impurity having a second conductive type opposite to a first conductive type on a front side of a substrate having the first conductive type;
forming a rear electric field layer by doping a second impurity having the first conductive type on a rear side of the substrate; and
forming a plurality of front finger lines adjoining the emitter layer and a plurality of rear finger lines adjoining the rear electric field layer;
wherein the emitter layer includes a plurality of first regions adjoining the plurality of front finger lines and a plurality of second regions disposed between the plurality of first regions, a doping concentration of the first regions is greater than a doping concentration of the plurality of second regions, and a doping thickness of the plurality of second regions is thicker than a doping thickness of the plurality of first regions.

14. The method of claim 13, wherein the rear electric field layer comprises:
a plurality of third regions to which the plurality of rear finger lines adjoin; and
a plurality of fourth regions disposed between the plurality of third regions;
wherein a doping concentration of the plurality of third regions is greater than a doping concentration of the plurality of fourth regions.

15. The method of claim 13, further comprising:
forming a first reflection preventing film on the emitter layer; and
forming a second reflection preventing film on the rear electric field layer.
